# DEMANDE DE BREVET EUROPEEN

(11) **EP 0 866 561 A1**
(43) Date de publication de la demande: **23.09.1998**
(21) Numéro de dépôt: 98200680.1
(22) Date de dépôt: 05.03.1998
(51) Int. Cl.: H03M 1/10

(54) **Dispositif de conversion analogique/numérique muni d'un agencement de calibration.**

(30) Priorité: 18.03.1997 FR 9703290
(71) Demandeur: Koninklijke Philips Electronics N.V., 5621 BA Eindhoven (NL)
(72) Inventeur: Morisson, Richard, 75008 Paris (FR); Gandy, Philippe, 75008 Paris (FR); Darthenay, Frédéric, 75008 Paris (FR)
(74) Mandataire: Caron, Jean

(57) **Abrégé**

La présente invention concerne un dispositif de conversion analogique/numérique, comportant :
. un amplificateur AMP muni de moyens de réglage, commandés par un signal de contrôle OC ou GC, pour ajuster la valeur de sa tension de sortie V2, et
. un convertisseur analogique/numérique ADC2, destiné à convertir en numérique la tension de sortie V2 de l'amplificateur AMP.

Selon l'invention, ce dispositif comporte des moyens SO ou MUX, pour placer l'entrée de l'amplificateur AMP à un potentiel de référence lorsqu'un signal de calibration CALOS ou CALG est actif, et au moins un agencement de calibration DECO ou DECM comprenant chacun :
. un module comparant la sortie du deuxième convertisseur ADC2 à un mot binaire prédéterminé,
. un module délivrant le signal de contrôle OC ou GC, dont la valeur dépend du résultat de la dite comparaison, et
. des moyens pour mémoriser le signal de contrôle OC ou GC lorsque le signal de calibration correspondant CALOS ou CALG est inactif.

Applications : Convertisseurs analogique/numérique à deux étages.

## Description

La présente invention concerne un dispositif de conversion analogique/numérique, présentant une entrée destinée à recevoir un signal analogique d'entrée et une sortie destinée à délivrer un signal numérique de sortie, comportant :
. un amplificateur présentant une sortie et une entrée destinée à recevoir le signal analogique d'entrée du dispositif, muni de moyens de réglage, commandés par un signal numérique dit de contrôle, pour ajuster la valeur d'une tension délivrée par la sortie de l'amplificateur,
. un convertisseur analogique/numérique, présentant une entrée analogique reliée à la sortie de l'amplificateur et une sortie destinée à délivrer le signal numérique de sortie du dispositif.

Un tel dispositif est décrit dans le brevet américain n° 5,313,207. Ce dispositif est mis en oeuvre au sein d'un circuit de conversion analogique/numérique possédant une structure dite à deux étages, où un signal analogique, dit primitif, est converti en numérique par un premier convertisseur analogique/numérique, lequel fournit en sortie un signal numérique appelé mot de poids fort qui constitue une approximation de la valeur numérique du signal analogique d'entrée et qui forme ainsi la partie la plus significative du signal de sortie numérique du circuit de conversion. Le mot de poids fort est converti en analogique par un convertisseur numérique/analogique qui fournit en sortie un signal appelé signal converti qui correspond à la transposition en analogique de la valeur numérique approchée fournie par le premier convertisseur analogique/numérique. Ce signal converti prend ici la forme d'un courant qui agit sur un dispositif conforme au paragraphe introductif, dans lequel l'amplificateur reçoit en entrée le signal analogique primitif. Dans ce dispositif, le signal de contrôle est en fait constitué par le mot de poids fort, l'opération consistant à ajuster la valeur de la tension de sortie de l'amplificateur via les moyens de réglage incorporant alors la conversion en analogique du dit mot. L'amplificateur délivre ainsi en sortie un signal analogique, appelé signal résidu, représentatif d'une erreur de quantification due à l'approximation effectuée par le premier convertisseur analogique/numérique, lequel signal résidu est converti au sein du dispositif par un deuxième convertisseur analogique/numérique en un signal numérique appelé mot de poids faible qui forme ainsi la partie la moins significative du signal de sortie numérique du circuit de conversion. L'amplificateur présent dans le dispositif de conversion analogique/numérique connu peut introduire une composante continue, appelée tension de décalage, dans le signal de sortie qu'il délivre. Ceci entraîne des conséquences néfastes sur la précision de la conversion analogique/numérique réalisée par le deuxième convertisseur. En effet, cette tension de décalage modifie artificiellement la valeur du signal qui parvient à l'entrée du dit convertisseur, et peut provoquer ainsi des discontinuités dans l'évolution de la valeur du signal de sortie du dispositif en fonction de l'évolution de la valeur du signal analogique primitif, ce qui n'est pas acceptable.

L'invention a pour but de remédier à cet inconvénient en proposant un dispositif de conversion analogique/numérique dans lequel la tension de décalage introduite par l'amplificateur est compensée au moyen d'une boucle de régulation.

En effet, un dispositif de conversion analogique/numérique selon la présente invention est caractérisé en ce qu'il présente une entrée destinée à recevoir un signal dit de calibration, et en ce qu'il comporte des moyens pour placer l'entrée de l'amplificateur à un potentiel de référence prédéterminé lorsque le signal de calibration est actif, et un agencement de calibration comprenant :
. un module de comparaison, actionné lorsque le signal de calibration est actif, comprenant un comparateur destiné à délivrer sur une sortie un signal représentatif d'au moins une comparaison entre le signal numérique de sortie et un mot binaire prédéterminé,
. un module de contrôle, présentant une entrée reliée à la sortie du module de comparaison et actionné quand le signal de calibration est actif, destiné à délivrer le signal de contrôle, dont la valeur dépend de la valeur d'un signal reçu par le module de contrôle sur son entrée, et
. des moyens de mémorisation dans lesquels est stockée la valeur du signal de contrôle lorsque le signal de calibration est inactif.

Un tel dispositif permet, lorsqu'il fonctionne en mode de calibration, c'est-à-dire lorsque le signal de calibration est actif, d'imposer un potentiel de valeur connue à l'entrée de l'amplificateur. La valeur du mot binaire prédéterminé correspond par convention à la valeur que doit prendre le signal numérique de sortie du dispositif lorsque, en fonctionnement normal, l'amplificateur reçoit sur son entrée une tension dont la valeur est égale à celle du potentiel de référence. En mode de calibration, toute différence existant entre le signal numérique de sortie du dispositif et le mot binaire prédéterminé est détectée par le module de comparaison, et compensée au moyen du signal de contrôle élaboré par le module de contrôle en fonction du résultat de la comparaison effectuée au sein du module de comparaison.

Par ailleurs, si l'invention permet une compensation de la tension de décalage introduite par l'amplificateur, il sera démontré dans la suite de l'exposé qu'elle peut également être mise en oeuvre pour réaliser un ajustement optimal de la valeur du gain du dit amplificateur. Cette possibilité confère un intérêt supplémentaire à l'invention, car un réglage imparfait du gain de l'amplificateur peut également provoquer des phénomènes de discontinuité tels qu'évoqués précédemment.

Dans un mode de réalisation particulier de l'invention, l'amplificateur comporte un premier et un deuxième transistors disposés en paire différentielle dont au moins une des bases forme l'entrée de l'amplificateur et dont au moins un des collecteurs, qui sont reliés à une même borne d'alimentation via deux résistances dites de charge, constitue la sortie de l'amplificateur.

Cette structure présente l'avantage de la simplicité, et permet une réalisation aisée de l'invention. En effet, un mode de réalisation particulièrement avantageux de celle-ci est caractérisé en ce que, la sortie de l'amplificateur étant de nature différentielle et constituée par les collecteurs des premier et deuxième transistors, le signal de contrôle délivré par le module de contrôle lorsque le signal de calibration est actif commande, via les moyens de réglage, une augmentation de la valeur du courant traversant celle des résistances de charge qui est reliée au collecteur dont le potentiel électrique est le plus élevé lorsque la valeur du signal numérique de sortie est supérieure à celle du mot binaire prédéterminé, et une augmentation de la valeur du courant traversant l'autre résistance de charge sinon

Le fait que l'entrée et la sortie de l'amplificateur soient de nature différentielle permet un rejet du mode commun, c'est-à-dire des composantes continues des signaux présents aux bases des transistors composant la paire différentielle. La composante continue du signal de sortie est alors en principe exclusivement due à l'existence d'une tension de décalage créée par l'amplificateur. Si le potentiel de référence est le potentiel nul, ce qui peut se traduire par la mise en court-circuit des bases des premier et deuxième transistors lorsque le signal de calibration est actif, le signal de sortie de l'amplificateur, défini par exemple comme étant la différence de potentiel entre les collecteurs des premier et deuxième transistors, doit être nul si l'on choisit pour le mot binaire prédéterminé la valeur médiane de l'excursion maximale obtenue en sortie du convertisseur analogique/numérique. Si, à l'issue de la comparaison, il apparaît que la dite différence de potentiel est positive, la tension de décalage doit être compensée en réduisant la valeur du potentiel du collecteur du premier transistor, ce qui est obtenu en augmentant la valeur du courant qui traverse la résistance de charge qui est reliée au dit collecteur, et donc la chute de tension aux bornes de celle-ci. Si la différence de potentiel entre les deux collecteurs est négative, c'est le potentiel du collecteur du deuxième transistor qui doit être diminué, ce qui est obtenu en augmentant la valeur du courant qui traverse la résistance de charge qui est reliée au dit collecteur.

Les moyens permettant le réglage des courants traversant les résistances de charge sont multiples. L'un de ceux-ci, avantageux de par la simplicité de sa mise en oeuvre, est caractérisé en ce que, les émetteurs des premier et deuxième transistors étant reliés à une deuxième borne d'alimentation via une première source de courant, les moyens de réglage comprennent une deuxième source de courant destinée à débiter vers la deuxième borne d'alimentation un courant dont la valeur est déterminée par la valeur des signaux de contrôle, la deuxième source de courant étant reliée en parallèle, via un premier et un deuxième interrupteurs destinés à être actionnés au moyen d'au moins un des bits du signal de contrôle, à deux noeuds situés chacun entre l'une des résistances de charge et la première source de courant.

Dans ce mode de réalisation, le résultat de la comparaison entre le signal numérique de sortie du dispositif et le mot binaire prédéterminé commande la fermeture de l'un des deux interrupteurs, provoquant ainsi la conduction du courant débité par la deuxième source de courant au travers de la résistance correspondante.

La précision du réglage décrit ci-dessus est améliorée dans une variante de l'invention, caractérisée en ce que :
. la deuxième source de courant comporte N sources de courant disposées en parallèle entre la deuxième borne d'alimentation et un noeud commun à toutes les sources, la valeur Iᵢ du courant nominal débité par la source de courant de rang i (pour i=1 à N) étant égale à IO/2⁽ⁱ⁻¹⁾ où IO est une valeur prédéterminée,
. le signal de contrôle est un mot binaire de N+1 bits dont un bit, appelé bit de correction, et son inverse logique commandent respectivement les premier et deuxième interrupteurs, chacun des bits restants commandant, lorsqu'il est à l'état actif, la conduction de l'une des N sources de courant constituant la deuxième source de courant.

Selon cette variante de l'invention, la valeur du courant additionnel parcourant la résistance de charge aux bornes de laquelle une chute de tension correctrice doit être générée est réglable. Ceci permet une compensation plus précise de la tension de décalage induite par l'amplificateur. De plus, le réglage se faisant par voie numérique, il est aisé de mémoriser le signal de contrôle correspondant dans un registre afin de maintenir la compensation de la tension de décalage lorsque le dispositif est en mode de fonctionnement normal.

Le module de contrôle peut élaborer la valeur optimale du signal de contrôle par approximations successives, et notamment en appliquant une méthode de dichotomie. Un mode de réalisation de cette variante de l'invention est donc caractérisé en ce que :
. le signal de calibration étant actif pendant au moins N fois une durée appelée cycle de comparaison au cours de laquelle un signal analogique présent à la sortie de l'amplificateur est converti en numérique, puis comparé au mot binaire prédéterminé, le module de comparaison est muni d'un registre destiné à mémoriser au cours d'un cycle dit de contrôle, dont la durée est au moins égale à celle d'un cycle de comparaison, la valeur prise par le signal de sortie du comparateur au cours d'au moins un des cycles de contrôle précédents,
. le module de contrôle est muni de moyens pour placer, au cours du premier cycle de contrôle, le bit de correction du signal de contrôle à l'état actif si la valeur du signal qu'il reçoit sur son entrée indique que la valeur du signal numérique de sortie est supérieure à la valeur du mot binaire prédéterminé et à l'état inactif sinon, et celui des bits commandant la conduction de la source de rang 1 systématiquement à l'état actif,
. le module de contrôle est muni de moyens pour placer systématiquement à l'état actif, au cours d'un quelconque cycle de contrôle suivant, le bit de rang suivant celui du bit, dit précédent, dont l'état a été modifié au cours du cycle précédent, le bit précédent étant inchangé si la valeur du signal qu'il reçoit sur son entrée est identique à celle du signal reçu à l'issue du cycle de contrôle précédent et inversé sinon, le processus se répétant jusqu'à ce que le signal de calibration retrouve l'état inactif.

Dans un mode de réalisation préféré de l'invention, un dispositif de conversion analogique/numérique tel que décrit ci-dessus est caractérisé en ce que :
. le signal de calibration étant actif pendant au moins N.P cycles de comparaison, chaque cycle de contrôle comprend P cycles de comparaison,
. le module de comparaison est muni d'un registre, destiné à mémoriser les valeurs prises par le signal de sortie du comparateur à l'issue de chacune des P comparaisons successives effectuées au cours d'un même cycle de contrôle, et d'un module de pondération, destiné délivrer sur une sortie un signal dont la valeur est représentative d'une moyenne des dites valeurs, la dite sortie formant la sortie du module de comparaison.

La pondération des résultats de P comparaisons successives permet d'éviter des oscillations dues à des corrections intempestives. En effet, la sortie du module de comparaison incluant un module de pondération est représentative d'une tendance matérialisée par au moins P/2 résultats de comparaison. Cette pondération permet donc de limiter les effets que produirait une différence fortuite entre le signal numérique de sortie du dispositif et le mot binaire prédéterminé, qui serait due par exemple à une conversion erronée.

Ainsi qu'exposé plus haut, un tel dispositif de conversion analogique/numérique peut être avantageusement mis en oeuvre au sein d'un circuit de conversion analogique/numérique présentant une structure dite à deux étages. L'invention concerne donc également un circuit de conversion analogique/numérique, présentant une entrée destinée à recevoir un signal analogique d'entrée et une sortie destinée à délivrer un signal numérique de sortie, comportant :
. un premier dispositif de conversion analogique/numérique présentant une entrée et une sortie respectivement destinées à recevoir le signal analogique d'entrée du circuit et à délivrer un signal de nature numérique, appelé mot de poids fort, constituant la partie la plus significative du signal numérique de sortie du circuit,
. un convertisseur numérique/analogique destiné à recevoir le mot de poids fort et à le convertir en un signal de sortie de nature analogique, appelé signal converti,
. un deuxième dispositif de conversion analogique/numérique, présentant une entrée analogique destinée à recevoir la différence entre le signal converti et le signal d'entrée du circuit, et une sortie destinée à délivrer un signal de nature numérique, appelé mot de poids faible, constituant la partie la moins significative du signal numérique de sortie du circuit,
   circuit de conversion caractérisé en ce qu'au moins un des deux dispositifs de conversion analogique/numérique est tel que décrit plus haut.

L'invention sera mieux comprise à l'aide de la description suivante de quelques modes de réalisation, faite à titre d'exemple non-limitatif et en regard des dessins annexés, dans lesquels :
- la figure 1 est un schéma de principe représentant un circuit de conversion analogique/numérique à deux étages qui met en oeuvre l'invention,
- la figure 2 est un schéma électrique décrivant un amplificateur présent dans un dispositif de conversion selon un mode de réalisation particulier de l'invention,
- la figure 3 est un schéma électrique décrivant une source de courant incluse dans un tel amplificateur, et
- la figure 4 est un schéma de principe représentant un agencement de calibration présent dans une variante de l'invention.

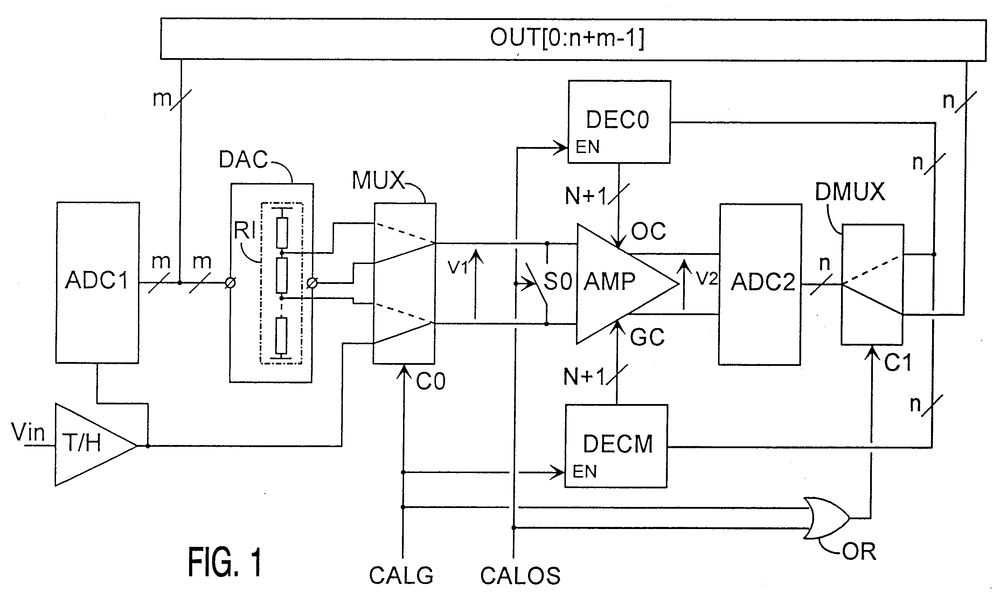

La figure 1 représente schématiquement un circuit de conversion analogique/numérique à deux étages qui met en oeuvre l'invention. Ce circuit présente une entrée destinée à recevoir un signal analogique d'entrée Vin, via dans cet exemple un suiveur/bloqueur T/H, et une sortie destinée à délivrer un signal numérique de sortie OUT[O:n+m-1], et comporte :
. un premier convertisseur analogique/numérique ADC1 présentant une entrée et une sortie respectivement destinées à recevoir le signal analogique d'entrée Vin du circuit et à délivrer un signal OUT[n:m-1] de nature numérique, appelé mot de poids fort, constituant la partie la plus significative du signal numérique de sortie OUT[O:n+m-1] du circuit,
. un convertisseur numérique/analogique DAC destiné à recevoir le mot de poids fort OUT[n:m-1] et à le convertir en un signal de sortie de nature analogique, appelé signal converti,
. un dispositif de conversion analogique/numérique, présentant une entrée analogique destinée à recevoir une tension V1, appelée signal résidu, qui représente la différence entre le signal converti et le signal d'entrée Vin du circuit, et une sortie destinée à délivrer un signal OUT[O:n-1] de nature numérique, appelé mot de poids faible, constituant la partie la moins significative du signal numérique de sortie OUT[O:n+m-1] du circuit.

Ce dispositif de conversion comporte :
. un amplificateur AMP présentant une sortie délivrant une tension V2 et une entrée différentielle destinée à recevoir le signal résidu V1, muni de moyens de réglage, commandés par des signaux numériques dits de contrôle OC et GC, pour ajuster la valeur de la tension V2 délivrée par la sortie de l'amplificateur AMP,
. un deuxième convertisseur analogique/numérique ADC2, présentant une entrée analogique reliée à la sortie de l'amplificateur AMP et recevant donc la tension V2, et une sortie destinée à délivrer le signal numérique de sortie du dispositif qui constitue le mot de poids faible OUT[O:n-1].

Le dispositif de conversion présente en outre deux entrées destinées à recevoir un signal de calibration de niveau continu CALOS et un signal de calibration de gain CALG. Il comporte un interrupteur SO pour placer l'entrée de l'amplificateur AMP à un potentiel nul en court-circuitant son entrée différentielle lorsque le signal de calibration de niveau continu CALOS est actif, et un multiplexeur MUX pour placer l'entrée de l'amplificateur AMP à un potentiel de référence lorsque le signal de calibration de gain CALG est actif. Dans cet exemple, le convertisseur numérique/analogique DAC réalise la conversion sur la base de tensions de référence élaborées au moyen d'une échelle RL de résistances de valeurs nominales identiques et disposées en série entre deux bornes d'alimentation. Cette échelle de résistances RL est avantageusement choisie comme étant la même que celle qui est utilisée au sein du premier convertisseur analogique/numérique ADC1. Ainsi, la valeur de la tension aux bornes d'une des résistances, qui correspond à la valeur analogique du bit le moins significatif du mot de poids fort OUT[n:m-1], détermine l'erreur de quantification maximale commise par le premier convertisseur analogique/numérique ADC1, et donc la valeur maximale du signal résidu V1. Le potentiel de référence utilisé pour la calibration du gain du dit amplificateur doit donc être égale à cette valeur maximale.

Le dispositif comporte un agencement de calibration de niveau continu DECO, qui, lorsque le signal de calibration de niveau continu CALOS est actif, reçoit par l'intermédiaire d'un démultiplexeur DMUX le mot de poids faible OUT[O:n-1], et le compare à un mot binaire prédéterminé, dont la valeur est la valeur médiane de l'excursion maximale obtenue en sortie du deuxième convertisseur analogique/numérique ADC2. L'agencement de calibration de niveau continu délivre un signal de contrôle de niveau continu OC, qui est de nature numérique et codé dans cet exemple sur N+1 bits. Le dispositif comporte de plus un agencement de calibration de gain DECM, qui, lorsque le signal de calibration de gain CALG est actif, reçoit par l'intermédiaire du démultiplexeur DMUX le mot de poids faible OUT[O:n-1], et le compare à un mot binaire prédéterminé, dont la valeur est, dans cette exemple, la valeur maximale que peut prendre la sortie du deuxième convertisseur analogique/numérique ADC2. L'agencement de calibration de gain délivre un signal de contrôle de gain OC, qui est de nature numérique et également codé dans cet exemple sur N+1 bits. Le démultiplexeur DMUX est donc commandé par l'un ou l'autre des signaux de calibration par l' intermédiaire de la porte "ou logique" OR.

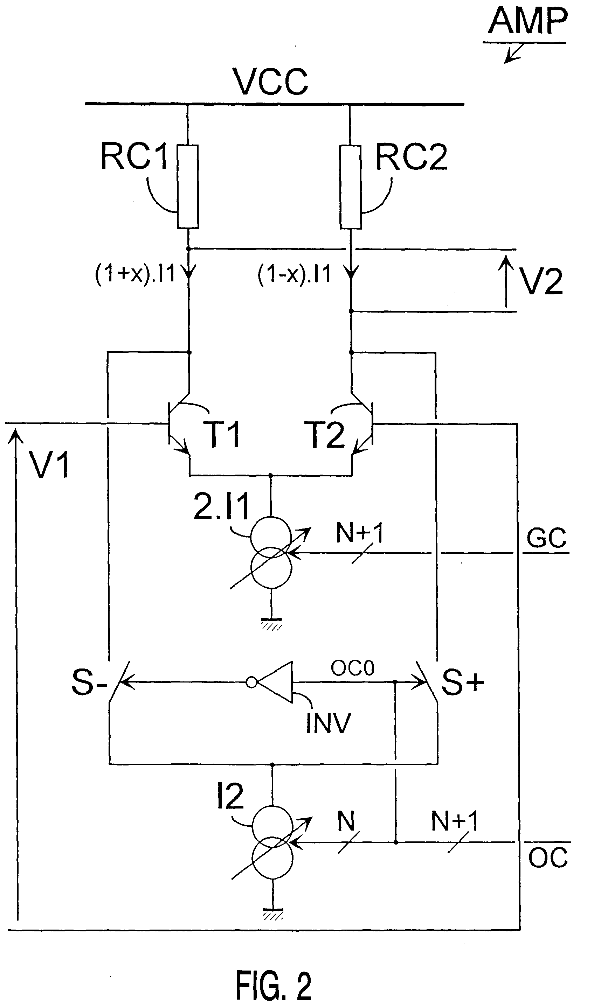

La figure 2 décrit schématiquement une structure choisie pour l'amplificateur AMP dans un mode de réalisation particulier de l'invention Cet amplificateur AMP comporte un premier et un deuxième transistors, T1 et T2, disposés en paire différentielle, dont les bases forment une entrée différentielle destinée à recevoir le signal résidu V1. Les premier et deuxième transistors sont en principe identiques, aux variations induites par le procédé de fabrication près. Les collecteurs des premier et deuxième transistors T1 et T2 sont reliés à une même borne d'alimentation VCC via deux résistances dites de charge RC1 et RC2, qui ont en principe des valeurs nominales identiques. La sortie de l'amplificateur AMP est de nature différentielle, constituée par les collecteurs des premier et deuxième transistors T1 et T2, et délivre la tension V2. Les émetteurs des premier et deuxième transistors T1 et T2 sont reliés à une deuxième borne d'alimentation qui forme la masse du circuit via une première source de courant Il. L'amplificateur AMP est muni de moyens de réglage de la tension V2 qu'il délivre à sa sortie, qui comprennent une deuxième source de courant destinée à débiter vers la masse du circuit un courant I2 dont la valeur est déterminée par la valeur du signal de contrôle de niveau continu OC. Cette deuxième source de courant est reliée en parallèle, via un premier et un deuxième interrupteurs S- et S+, destinés à être actionnés au moyen d'un bit OCO du signal de contrôle OC, aux collecteurs des premier et deuxième transistors T1 et T2. Il est bien sûr envisageable de relier, dans une variante de ce mode de réalisation, la deuxième source de courant aux émetteurs des dits transistors. Le signal de contrôle de niveau continu OC, délivré par l'agencement de calibration de niveau continu lorsque le signal de calibration de niveau continu est actif, commande les moyens de réglage décrits ci-dessus. Lorsque la valeur du mot de poids faible OUT[O:n-1] du dispositif est supérieure à la valeur médiane de l'excursion maximale obtenue en sortie du deuxième convertisseur analogique/numérique ADC2, cela signifie que la tension V2 est positive, alors qu'elle devrait être nulle puisque les entrées de l'amplificateur AMP sont court-circuitées. Ceci traduit la présence d'une tension de décalage induite par l'amplificateur AMP, qui doit être compensée par une augmentation de la valeur du courant traversant la résistance de charge RC1. Le bit OCO prend alors un état logique O qui, inversé au moyen de l'inverseur INV, commande la fermeture de l'interrupteur S-, l'interrupteur S+ restant ouvert. La résistance RC1 est alors parcourue par un courant additionnel I2, qui provoque l'augmentation de la valeur de la chute de tension présente aux bornes de la résistance de charge RG1, et donc la diminution vers zéro de la tension de sortie V2. Inversement, si la valeur du mot de poids faible OUT[O:n-1] est inférieure à celle du mot binaire prédéterminé, cela signifie que la tension V2 est négative, alors qu'elle devrait être nulle. Cette tension de décalage induite par l'amplificateur AMP doit être compensée par une augmentation de la valeur du courant traversant la résistance de charge RC2. Le bit OCO prend alors un état logique 1 qui commande la fermeture de l'interrupteur S+, l'interrupteur S-restant ouvert. La résistance RC2 est alors parcourue par un courant additionnel I2, qui provoque l'augmentation de la valeur de la chute de tension présente aux bornes de la résistance de charge RC2, et donc l'augmentation vers zéro de la tension de sortie V2. Le réglage de la valeur du courant I2 débité par la deuxième source de courant sera décrit dans la suite de l'exposé.

Les moyens de réglage prévoient également la possibilité de faire varier la valeur du courant I1 débité par la première source de courant. Ceci permet de régler la valeur du gain de l'amplificateur AMP à une valeur optimale, qui permet au dispositif de conversion de délivrer un mot de poids faible OUT[O:n-1] qui prend sa valeur maximale lorsque l' amplificateur AMP reçoit sur son entrée une tension V1 dont la valeur est la valeur analogique du bit le moins significatif du mot de poids fort OUT[n:m-1]. En effet, il apparaît clairement sur la figure que la valeur de la tension V2 est, si la tension de décalage est nulle ou parfaitement compensée, directement dépendante du courant I1 débité par la première source de courant. Si RC1=RC2=RC, la tension V2 s'exprime V2=2.RC.x.I1, où x représente un taux de conduction du premier transistor T1 par rapport au deuxième transistor T2. Une variation de la valeur de I1 provoque donc une variation de la valeur de la tension de sortie V2 de l'amplificateur AMP. A la différence de la deuxième source de courant, la première source de courant doit être toujours conductrice puisqu'elle polarise la paire différentielle T1, T2. La valeur du courant I1 qu'elle débite évolue de la manière suivante : lorsque la valeur du mot de poids faible OUT[O:n-1] est inférieure à la valeur maximale que peut prendre la sortie du deuxième convertisseur analogique/numérique ADC2, cela signifie que la tension V2, et donc le gain de l'amplificateur AMP, est trop faible, ce qui doit être compensé par une augmentation de la valeur du courant I1 dèbité par la première source de courant. Si la valeur du mot de poids faible OUT[O:n-1] est égale à la valeur maximale que peut prendre la sortie du deuxième convertisseur analogique/numérique ADC2, cela peut signifier que le gain de l'amplificateur AMP est trop important et que le deuxième convertisseur analogique/numérique ADC2 se trouve dans un mode dit de saturation, c'est-à-dire qu'il délivre le même signal de sortie pour tous les signaux d'entrée qu'il reçoit dont la valeur dépasse un certain seuil. Le gain de l'amplificateur AMP est donc réduit au moyen du signal de contrôle de gain GC qui opère une diminution de la valeur du courant I1 débité par la première source de courant. Si, après cette correction, il s'avère que la valeur du mot de poids faible OUT[O:n-1] est toujours égale à la valeur maximale que peut prendre la sortie du deuxième convertisseur analogique/numérique ADC2, cela signifie bien que le gain de l'amplificateur AMP est trop important et que le deuxième convertisseur analogique/numérique se trouve en mode de saturation. Le gain de l'amplificateur AMP doit donc être à nouveau réduit. L'équilibre recherché est signalé par un changement du résultat de la comparaison décrite plus haut. Lorsque ce changement survient, le réglage précédent de la valeur du signal de contrôle de gain GC, qui a été préalablement mémorisée dans un registre, est validé et sera utilisé en mode de fonctionnement normal du dispositif.

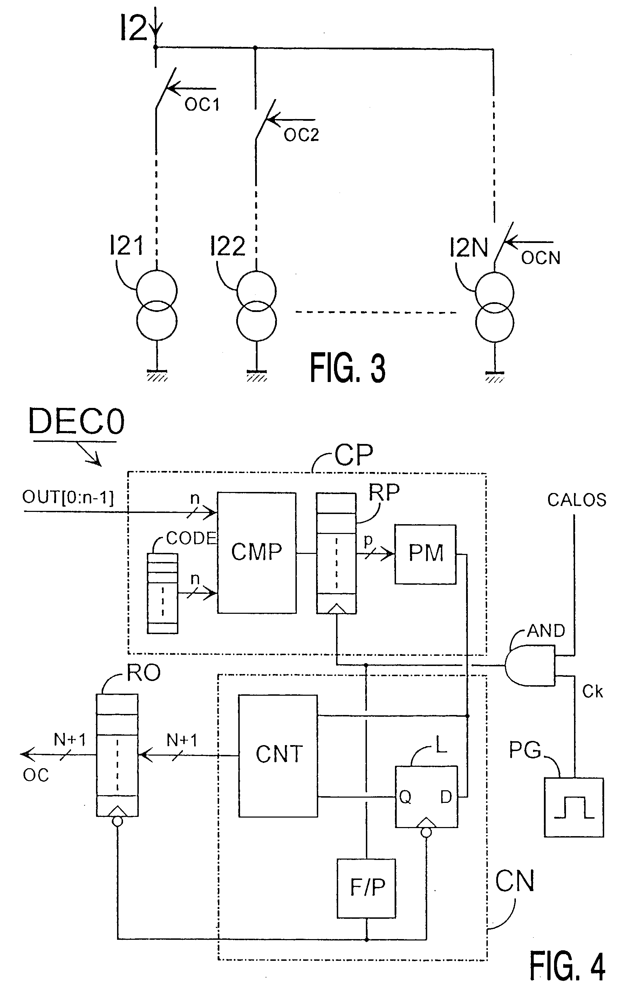

La figure 3 décrit schématiquement un mode de réalisation d'une de la deuxième source de courant, et le dispositif employé pour régler la valeur du courant I2 débité par celle-ci. Cette source comporte N sources de courant disposées en parallèle entre la masse du circuit et un noeud commun à toutes les sources, qui est destiné à être parcouru par le courant I2. La valeur I2ᵢ du courant nominal débité par la source de courant de rang i (pour i=1 à N) est égale à IO/2⁽ⁱ⁻¹⁾ où IO est une valeur prédéterminée. Conformément à ce qui a été exposé précédemment, le signal de contrôle de niveau continu OC est un mot binaire de N+1 bits dont un bit OCO, appelé bit de correction, et son inverse logique commandent respectivement les premier et deuxième interrupteurs S+ et S- permettant la compensation de la tension de décalage au sein de l'amplificateur AMP. Chacun des bits restants OCi, pour i=1 à N, commande, lorsqu' il est à l'état actif, la conduction de l'une des N sources de courant I2ᵢ, pour i=1 à N, constituant la deuxième source de courant. Une structure similaire sera avantageusement choisie pour réaliser la première source de courant commandée par le signal de contrôle de gain GC.

La figure 4 représente schématiquement l'agencement de calibration de niveau continu DECO présent dans une variante de l'invention. Cet arrangement comporte :
. un module de comparaison CP, comprenant un comparateur CMP destiné à délivrer sur une sortie un signal représentatif d'au moins une comparaison entre le signal numérique de sortie OUT[O:n-1] du deuxième convertisseur ADC2 et un mot binaire prédéterminé, qui est stocké dans un registre CODE et dont la valeur est la valeur médiane de l'excursion maximale obtenue en sortie du deuxième convertisseur analogique/numèrique ADC2,
. un module de contrôle CN, présentant une entrée reliée à la sortie du module de comparaison CP, destiné à délivrer le signal de contrôle de niveau continu OC, dont l'élaboration sera décrite plus loin, et
. un registre RO dans lequel est stockée la valeur du signal de contrôle OG lorsque le dispositif de conversion se trouve en mode de fonctionnement normal.

L'agencement de calibration DECO reçoit le signal de calibration CALOS qui est actif pendant au moins N fois une durée appelée cycle de comparaison au cours de laquelle la tension de sortie V2 de l'amplificateur AMP est convertie en numérique par le deuxième convertisseur analogique/numérique ADC2, puis comparée au mot binaire stocké dans le registre CODE. Le module de comparaison CP est muni d'un registre RP destiné à mémoriser au cours d'un cycle dit de contrôle, dont la durée est au moins égale à celle d'un cycle de comparaison, la valeur prise par le signal de sortie du comparateur CMP au cours d'au moins un des cycles de contrôle précédents.

Dans la variante de l'invention décrite ici, le signal de calibration CALOS est en fait actif pendant au moins N.P cycles de comparaison, et chaque cycle de contrôle comprend P cycles de comparaison. Le registre RP du module de comparaison CP est cadencé par un signal d'horloge Ck délivré par un générateur d'impulsions PG, et validé par le signal de calibration de niveau continu CALOS au moyen d'une porte "et logique" AND. Ce registre RP est destiné à mémoriser les valeurs prises par le signal de sortie du comparateur CMP à l'issue de chacune des P comparaisons successives effectuées au cours d'un même cycle de contrôle. Le module de comparaison CP est de plus muni d'un module de pondération PM destiné délivrer sur une sortie un signal dont la valeur est représentative d'une moyenne des dites valeurs, la dite sortie formant la sortie du module de comparaison CP. Ainsi, le signal de sortie du module de comparaison CP est représentatif d'une tendance matérialisée par au moins P/2 résultats de comparaison identiques, ce qui permet d'éviter des oscillations résultant de corrections intempestives provoquées par des différences fortuites entre le signal numérique de sortie OUT[O:n-1] du deuxième convertisseur analogique/numérique ADC2 qui seraient dues par exemple à une conversion erronée. Le module de contrôle CN comprend une bascule mémoire L destinée à mémoriser au cours d'un cycle de contrôle la valeur du signal de sortie du module de comparaison CP à l'issue du cycle précédent. Un cycle de contrôle durant P cycles de comparaison, cette bascule L est cadencée par un signal issu d'un diviseur de fréquence F/P, qui reçoit en entrée le signal d'horloge Ck et délivre un signal dont la fréquence est P fois plus faible. Le module de contrôle CN place, au cours du premier cycle de contrôle, le bit de correction OCO du signal de contrôle de niveau continu OC à l'état actif si la valeur du signal délivré par le module de comparaison indique que la valeur du signal numérique de sortie OUT[O:n-1] du deuxième convertisseur analogique/numérique ADC2 est supérieure à la valeur du mot binaire stocké dans le registre CODE et au niveau inactif sinon, et le bit OC1 systématiquement à l'état actif. Au cours d'un quelconque cycle de contrôle suivant, le module de contrôle CN place systématiquement le bit de rang suivant celui du bit, dit précédent, dont l'état a été modifié au cours du cycle précédent à l'état actif, le bit précédent étant inchangé si la valeur du signal délivrée par le module de comparaison CP est identique à celle du signal délivré à l'issue du cycle de contrôle précédent, et inversé sinon. Ce processus se répète jusqu'à ce que le signal de calibration de niveau continu CALOS retrouve l'état inactif, provoquant ainsi la mémorisation du signal de contrôle de niveau continu OC dans le registre RO. Une structure similaire à celle décrite ci-dessus sera avantageusement choisie pour réaliser l'agencement de calibration de gain DECM.

## Revendications

1. Dispositif de conversion analogique/numérique, présentant une entrée destinée à recevoir un signal analogique d'entrée et une sortie destinée à délivrer un signal numérique de sortie, comportant :
. un amplificateur présentant une sortie et une entrée destinée à recevoir le signal analogique d'entrée du dispositif, muni de moyens de réglage, commandés par un signal numérique dit de contrôle, pour ajuster la valeur d'une tension délivree par la sortie de l'amplificateur,
. un convertisseur analogique/numérique, présentant une entrée analogique reliée à la sortie de l'amplificateur et une sortie destinée à délivrer le signal numérique de sortie du dispositif,
dispositif de conversion caractérisé en ce qu'il présente une entrée destinée à recevoir un signal dit de calibration, et en ce qu'il comporte des moyens pour placer l'entrée de l'amplificateur à un potentiel de référence prédéterminé lorsque le signal de calibration est actif, et un agencement de calibration comprenant :
. un module de comparaison, actionné lorsque le signal de calibration est actif, comprenant un comparateur destiné à délivrer sur une sortie un signal représentatif d'au moins une comparaison entre le signal numérique de sortie et un mot binaire prédéterminé,
. un module de contrôle, présentant une entrée reliée à la sortie du module de comparaison et actionné quand le signal de calibration est actif, destiné à délivrer le signal de contrôle, dont la valeur dépend de la valeur d'un signal reçu par le module de contrôle sur son entrée, et
. des moyens de mémorisation dans lesquels est stockée la valeur du signal de contrôle lorsque le signal de calibration est inactif.

2. Dispositif de conversion analogique/numérique selon la revendication 1, caractérisé en ce que l'amplificateur comporte un premier et un deuxième transistors disposés en paire différentielle dont au moins une des bases forme l'entrée de l'amplificateur et dont au moins un des collecteurs, qui sont reliés à une même borne d'alimentation via deux résistances dites de charge, constitue la sortie de l'amplificateur.

3. Dispositif de conversion analogique/numérique selon la revendication 2, caractérisé en ce que, la sortie de l'amplificateur étant de nature différentielle et constituée par les collecteurs des premier et deuxième transistors, le signal de contrôle délivré par le module de contrôle lorsque le signal de calibration est actif commande, via les moyens de réglage, une augmentation de la valeur du courant traversant celle des résistances de charge qui est reliée au collecteur dont le potentiel électrique est le plus élevé lorsque la valeur du signal numérique de sortie est supérieure à celle du mot binaire prédéterminé, et une augmentation de la valeur du courant traversant l'autre résistance de charge sinon.

4. Dispositif de conversion analogique/numérique selon la revendication 3, caractérisé en ce que, les émetteurs des premier et deuxième transistors étant reliés à une deuxième borne d'alimentation via une première source de courant, les moyens de réglage comprennent une deuxième source de courant destinée à débiter vers la deuxième borne d'alimentation un courant dont la valeur est déterminée par la valeur des signaux de contrôle, la deuxième source de courant étant reliée en parallèle, via un premier et un deuxième interrupteurs destinés à être actionnés au moyen d'au moins un des bits du signal de contrôle, à deux noeuds situés chacun entre l'une des résistances de charge et la première source de courant.

5. Dispositif de conversion analogique/numérique selon la revendication 4, caractérisé en ce que :
. la deuxième source de courant comporte N sources de courant disposées en parallèle entre la deuxième borne d'alimentation et un noeud commun à toutes les sources, la valeur Iᵢ du courant nominal débité par la source de courant de rang i (pour i=1 à N) étant égale à IO/2(i-1) ou IO est une valeur prédéterminée,
. le signal de contrôle est un mot binaire de N+1 bits dont un bit, appelé bit de correction, et son inverse logique commandent respectivement les premier et deuxième interrupteurs, chacun des bits restants commandant, lorsqu'il est à l'état actif, la conduction de l'une des N sources de courant constituant la deuxième source de courant.

6. Dispositif de conversion analogique/numérique selon la revendication 5, caractérisé en ce que :
. le signal de calibration étant actif pendant au moins N fois une durée appelée cycle de comparaison au cours de laquelle un signal analogique présent à la sortie de l'amplificateur est converti en numérique, puis comparé au mot binaire prédéterminé, le module de comparaison est muni d'un registre destiné à mémoriser au cours d'un cycle dit de contrôle, dont la durée est au moins égale à celle d'un cycle de comparaison, la valeur prise par le signal de sortie du comparateur au cours d'au moins un des cycles de contrôle précédents,
. le module de contrôle est muni de moyens pour placer, au cours du premier cycle de contrôle, le bit de correction du signal de contrôle à l'état actif si la valeur du signal qu'il reçoit sur son entrée indique que la valeur du signal numérique de sortie est supérieure à la valeur du mot binaire prédéterminé et à l'état inactif sinon, et celui des bits commandant la conduction de la source de rang 1 systématiquement à l'état actif,
. le module de contrôle est muni de moyens pour placer systématiquement à l'état actif, au cours d'un quelconque cycle de contrôle suivant, le bit de rang suivant celui du bit, dit précédent, dont l'état a été modifié au cours du cycle précédent, le bit précédent étant inchangé si la valeur du signal qu'il reçoit sur son entrée est identique à celle du signal reçu à l'issue du cycle de contrôle précédent et inversé sinon, le processus se répétant jusqu'à ce que le signal de calibration retrouve l'état inactif.

7. Dispositif de conversion analogique/numérique selon la revendication 6, caractérisé en ce que :
. le signal de calibration étant actif pendant au moins N.P cycles de comparaison, chaque cycle de contrôle comprend P cycles de comparaison,
. le module de comparaison est muni d'un registre, destiné à mémoriser les valeurs prises par le signal de sortie du comparateur à l'issue de chacune des P comparaisons successives effectuées au cours d'un même cycle de contrôle, et d'un module de pondération, destiné délivrer sur une sortie un signal dont la valeur est représentative d'une moyenne des dites valeurs, la dite sortie formant la sortie du module de comparaison.

8. Circuit de conversion analogique/numérique, présentant une entrée destinée à recevoir un signal analogique d'entrée et une sortie destinée à délivrer un signal numérique de sortie, comportant :
. un premier dispositif de conversion analogique/numérique présentant une entrée et une sortie respectivement destinées à recevoir le signal analogique d'entrée du circuit et à délivrer un signal de nature numérique, appelé mot de poids fort, constituant la partie la plus significative du signal numérique de sortie du circuit,
. un convertisseur numérique/analogique destiné à recevoir le mot de poids fort et à le convertir en un signal de sortie de nature analogique, appelé signal converti,
. un deuxième dispositif de conversion analogique/numérique, présentant une entrée analogique destinée à recevoir la différence entre le signal converti et le signal d'entrée du circuit, et une sortie destinée à délivrer un signal de nature numérique, appelé mot de poids faible, constituant la partie la moins significative du signal numérique de sortie du circuit,
circuit de conversion caractérisé en ce qu'au moins un des deux dispositifs de conversion analogique/numérique est conforme à l'une quelconque des revendications 1 à 7.
